# EUROPÄISCHE PATENTANMELDUNG

(11) **EP 1 916 562 A2**
(43) Veröffentlichungstag der Anmeldung: **30.04.2008**
(21) Anmeldenummer: 07020710.5
(22) Anmeldetag: 23.10.2007
(51) Int. Cl.: G02F 1/01, H01S 3/04, H01S 3/034, H01S 3/06

(54) **Anordnung sowie ein Verfahren zur Vermeidung der Depolarisation von linear-polarisiertem Licht beim Durchstrahlen von Kristallen**

(30) Priorität: 23.10.2006 DE 102006049846; 23.10.2006 US 853581 P
(71) Anmelder: Schott AG, 55122 Mainz (DE)
(72) Erfinder: Natura, Ute, Dr., 07743 Jena (DE); Letz, Martin, Dr., 55128 Mainz (DE); Parthier, Lutz, Dr., 14532 Kleinmachnow (DE)
(74) Vertreter: Fuchs

(57) **Zusammenfassung**

Es wird ein Verfahren und eine Vorrichtung beschrieben, mit der die Depolarisation von linear polarisiertem Licht beim Durchstrahlen von Kristallen, die eine {111}- bzw. {100}-Kristallebene und eine 〈100〉- bzw. 〈111〉-Kristallachse aufweisen, vermieden werden kann. Die Vorrichtung zeichnet sich dadurch aus, dass das linear-polarisierte Licht in einem Winkel von 45-75° auf die Oberfläche der Kristalle auftrifft, wobei die Oberfläche von der {111}- oder {100}-Ebene gebildet wird. Dabei wird der Kristall derart angeordnet, dass das Licht nach seinem Eintritt im Kristall sich so parallel wie möglich entlang der 〈100〉- bzw. 〈111〉-Kristallachse ausbreitet und/oder dass die Vorrichtung zur Verhinderung eines Temperaturgradienten im Kristall eine Temperiereinheit umfasst. Die Vorrichtung wird vorzugsweise in der DUV-Lithographie, insbesondere in Steppern und Excimer-Lasern sowie zur Herstellung von integrierten Schaltungen, Computerchips sowie elektronischer Geräte wie Computern sowie anderer Geräte, welche chipartige integrierte Schaltungen enthalten, sowie von Flachbildschirmen verwendet.

## Beschreibung

Die Erfindung betrifft eine Anordnung sowie ein Verfahren zur Vermeidung bzw. Verringerung der Depolarisation von linear-polarisiertem Licht beim Durchstrahlen eines optischen Mediums, insbesondere von Kristallen. Die Erfindung betrifft auch die Verwendung einer solchen Vorrichtung.

Linear-polarisiertes Licht ist eine elektromagnetische, sich transversal ausbreitende Welle, die nur in einer Ebene quer zur Ausbreitungsrichtung schwingt. Ist das Licht darüber hinaus noch kohärent, so verlaufen sämtliche Wellen synchron. Ein Lichtstrahl besteht nun aus einem Bündel solcher einzelnen, gleich ausgerichteten Wellen. Linear-polarisiertes Licht findet in einem großen Bereich der Technik Anwendung, wie beispielsweise bei der Herstellung von Computerchips oder auch in Flachbildschirmen wie den TFT-Monitoren. Trifft linear-polarisiertes Licht auf einen Polarisationsfilter, der nur für Licht einer bestimmten Schwingungsebene durchlässig ist, dann ist er je nach Lage zur Schwingungsebene eines polarisierten Lichtstrahls für diesen ungehindert durchlässig oder auch undurchlässig (vertikale und horizontale Einstellung). Die Erzeugung polarisierten Lichtes ist seit langem bekannt und erfolgt beispielsweise mittels doppelbrechenden Kristallen wie Kalkspat (CaCO₃).

Eine weitere Möglichkeit zur Erzeugung polarisierten Lichtes oder polarisierter Strahlung ist die Reflektion an einer Oberfläche unter dem Brewsterwinkel. Wird Licht oder Strahlung unter dem Brewsterwinkel reflektiert und gebrochen, so ist der reflektierte Strahl vollständig in der Richtung senkrecht zur Brechungs- bzw. Reflexionsebene polarisiert (s-Polarisation), der durchgehende Strahl enthält den gesamten Anteil der parallel zur Brechungs- bzw. Reflexionsebene polarisierten Strahlung ohne Reflexionsverluste (p-Polarisation) sowie einen Anteil s-polarisierter Strahlung.

Eine Vorrichtung zur Ausnutzung dieser Effekte ist beispielsweise ein Nicolsches Prisma oder ein Brewster-Prisma, welches p-polarisierte Strahlung verlustfrei um 90° umlenkt. Weitere Beispiele sind im Brewsterwinkel angeordnete Laserfenster oder auch im Brewsterwinkel angeordnete Prismen, welche für p-polarisierte Strahlung die Transmission ohne Reflexionsverluste und für s-polarisierte Strahlung nur eine geringe Transmission ermöglichen und speziell am Beispiel des Lasers für die Erzeugung polarisierten Lichtes genutzt werden können, wie dies in der US 6,556,613 beschrieben ist. Eine weitere Vorrichtung zur Erzeugung derartiger polarisierter Strahlung ist beispielsweise ein Laser. Laserstrahlung, insbesonders pulsierende Laserstrahlung zeichnet sich dadurch aus, dass je nach Typ und Anordnung mit einer solchen Vorrichtung nicht nur ein kohärentes Laserlicht sondern auch ein polarisiertes oder auch unpolarisiertes Laserlicht erzeugt werden kann. Dies erfolgt beispielsweise bei einem Excimerlaser für die Mikrolithographie dadurch, dass optische Komponenten (z. B. Prismen und Austrittsfenster) im Brewsterwinkel angeordnet werden, um eine Polarisationsrichtung auszukoppeln.

Es ist jedoch seit langem bekannt, dass beim Durchtritt von linear-polarisiertem Laserlicht durch ein optisches Medium, wie beispielsweise eine Linse oder ein Prisma etc., dieses seine Polarisierung teilweise verliert, d. h. depolarisiert wird. Dadurch entsteht aus linear polarisiertem Licht elliptisch polarisiertes Licht oder es kommt zu einer Veränderung der Schwingungsrichtung. Dieser Effekt ist an sich bekannt.

In der TFT-Technologie passiert das Hintergrundlicht zuerst einen vertikal ausgerichteten Polfilter und anschließend einen variablen Polfilter, dessen Polarisationsrichtung durch Anlegen einer elektrischen Spannung von vertikal zu horizontal umgepolt werden kann. Auf diese Weise kann das Hintergrundlicht (bei horizontaler Einstellung) vollständig blockiert oder (bei vertikaler Einstellung) vollständig durchgelassen werden. Erfährt jedoch in einem solchen Fall das polarisierte Licht zwischen den Filtern eine Depolarisation, so lässt sich das Licht nicht mehr völlig auslöschen bzw. kann nicht mehr im vollen Umfang durch die Filteranordnung hindurchtreten, d. h. sowohl Helligkeit als auch Dunkelheit verlieren an Intensität.

Ein weiteres großes technisches Problem ist die Depolarisation von polarisiertem Laserlicht. Ein derartiger Effekt führt insbesonders bei der Herstellung von Halbleitern und anderen elektronischen Bauteilen zu Ungenauigkeiten in der Abbildung. So beschreibt bereits J. H. Burnett in Phys. Rev. B, Vol. 64, (2001), 241102(R), 1-4 die intrinsische Doppelbrechung an Calciumfluorid- und Bariumfluoridkristallen, wie sie beispielsweise für die zuvor genannte Herstellung elektronischer Bausteine eingesetzt werden. In derartigen rein kubisch symmetrischen Systemen ist es nämlich theoretisch nicht zu erwarten, dass überhaupt eine Doppelbrechung, d. h. richtungsabhängige Unterschiede in optischen Eigenschaften wie Absorption und Brechungsindex erfolgen. Zur Vermeidung derartiger durch Depolarisation erzeugter Probleme bei der Belichtung in der Präzisions-UV-Technologie wird in der (WO 02/093201 A2) vorgeschlagen, unterschiedlich orientierte Linsensysteme zu verwenden, nämlich eine Kombination von 2 {111}- (Oberflächennormale) orientierten Linsen, die um 60° gegeneinander rotiert sind und 2 {100}- orientierten Linsen, die um 45° gegeneinander rotiert sind.

M. Letz et al. beschreiben in "Proceedings of SPIE", Vol. 4691, pp. 1761-1768 (2002) ebenfalls die an sich überraschende Spannungsdoppelbrechung an rein kubischen Kristallsystemen wie CaF₂. Dabei wird der Zusammenhang zwischen der optischen Anisotropie und der Dispersion des Gamma Excitons beschrieben. Experimentell wurde dieser Zusammenhang mit Hilfe von Synchrotronstreuung nachgewiesen (M. Letz, et al. Phys. Rev. B, 67, 233101 (2003)).

Die Erfindung hat daher zum Ziel, die zuvor genannten Probleme, welche durch Depolarisation von linear-polarisiertem Licht in optischen Systemen, wie Laservorrichtungen, Flachbildschirmen sowie insbesonders bei der Herstellung von elektronischen Bauteilen etc. entstehen, zu überwinden. Die Erfindung hat insbesondere zum Ziel, nicht nur die durch die oben beschriebenen intrinsischen Effekte erzeugte Depolarisation zu vermeiden, sondern auch die Depolarisation, die durch durch Temperaturgradienten eingetragene Spannungen erzeugt wird.

Dieses Ziel wird durch die in den Ansprüchen definierten Merkmale erreicht.

Erfindungsgemäß wurde nämlich gefunden, dass die Depolarisation von polarisiertem Licht an optischen Elementen dadurch hervorgerufen wird, dass ein Temperaturgradient entsteht. Dies bedeutet, dass durch Vermeidung eines solchen Temperaturgradienten eine Depolarisation von linear-polarisiertem Licht verhindert werden kann. Vorzugsweise wird die Ausbildung eines Temperaturgradienten in sämtliche Raumrichtungen verhindert. In einer erfindungsgemäßen Ausführungsform wird insbesondere der Temperaturgradient verhindert, der entsteht, wenn die Temperatur des Lasergases innerhalb der Laserkammer von der Temperatur außerhalb der Laserkammer abweicht. Die äußere Temperatur wird üblicherweise durch die Temperatur des Spülgases bestimmt.

Erfindungsgemäß wurde auch gefunden, dass sich die Depolarisation von polarisiertem Licht bzw. Strahlung in kristallinem Material auch verhindern lässt, wenn das Licht bzw. die Strahlung auf eine Oberfläche des Kristalls bzw. des kristallinen optischen Elementes trifft, die aus der {111}- bzw. {100}-Kristallebene gebildet ist. Wird dann der Kristall bzw. das optische Element derart gedreht, dass die Ausbreitung des Lichtes im Kristall entlang der kristallinen 〈100〉- bzw. 〈111〉-Achse erfolgt, dann ist eine Depolarisation beim Durchtritt durch den Kristall zu verhindern bzw. zu minimieren. Der Lichtstrahl kann in einem beliebigen Winkel auf die Oberfläche auftreffen. In einer bevorzugten Ausführungsform bildet der auftreffende Lichtstrahl mit der Oberfläche einen Winkel von 45-75°, wobei der Brewsterwinkel besonders bevorzugt ist.

In einer erfindungsgemäß bevorzugten Ausführungsform werden beide Effekte kombiniert.

Kristallsysteme werden mittels zwei Koordinatensystemen beschrieben. Einmal durch das "direkte einfache Bravais Gitter", das durch Vektoren aufgespannt wird, welche die primitive Einheitszelle mit der Symmetrie des Gitters bilden. Im kubischen Calciumfluorid z. B. sind das die Einheitsvektoren, die zwei direkt benachbarte F Ionen verbinden a1,a2,a3. In diesem Koordinatensystem werden spezielle Richtungen, wie z.B. die [1,1,0] Richtung mit eckigen Klammern angegeben. Allgemeine Richtungen, wie z.B. alle zu [1,1,0] äquivalenten Richtungen ([1,1,0], [1,-1,0], [1,0,1], [1,0,-1], [0,1,1], [0,1,-1]) werden mit spitzen Klammern < > als <1,1,0> bezeichnet.

Das zweite Koordinatensystem, das sogenannte reziproke Gitter, wird durch die Vektoren aufgespannt, die auf der durch je zwei Basisvektoren des "direkten einfachen Bravais Gitters" aufgespannten Ebene senkrecht stehen. Im kubischen Kristallsystem wie Calciumfluorid sind diese beiden Koordinatensysteme identisch. Die Einheitsvektoren des reziproken Gitters, b1,b2,b3 zeigen in die selbe Richtung wie die Einheitsvektoren des "direkten einfachen Bravais Gitters", a1,a2,a3. Dennoch wird, um eine Verallgemeinerung auf nicht kubische Gitter zu erleichtern, hier eine andere Schreibweise verwendet. Der Normalenvektor auf einer Gitterebene in den Koordinaten des reziproken Gitters wird mit runden Klammern bezeichnet (h, k, l) = h b1 +k b2 + l b3, z.B. (1,1,1) die Ebene wird dann als (1,1,1) Ebene bezeichnet. Die Indizes (h,k,l) sind Miller Indizes. Die Gesamtheit aller zur (1,1,1) Ebene äquivalenten Ebenen ((1,1,1), (-1,1,1), (1,-1,1),(1,1,-1)) wird mit geschweiften Klammern als {1,1,1} Ebene bezeichnet. Das heißt, im kubischen Kristall liegen die Gitterebenen mit den Miller Indizes (h,k,l) senkrecht zur Kristallrichtung [h,k,l]. Die Kristallebenen werden im Folgenden durch ihre Miller Indizes mit {h,k,l} bezeichnet.

Die Ausbreitungsrichtung von elektromagnetischer Strahlung (hier im Wesentlichen die 193 nm Laserstrahlung) ist durch den Wellenvektor k gegeben. Die Ausbreitungsrichtung wird durch eine Orientierung im Kristall mit <mno> bezeichnet.

Die Verhinderung eines Temperaturgradienten in Ausbreitungsrichtung des Lichtes, d. h. in Richtung des transversalen Lichtstrahles, erfolgt erfindungsgemäß mittels einer Temperiereinheit. Eine derartige Temperiereinheit kann sowohl ein Kühlelement als auch ein Heizelement sein. Derartige Elemente sind beispielsweise ein Peltierelement, eine Vorrichtung zum Anströmen eines erwärmten Fluids wie beispielsweise ein Gas, insbesonders Luft und/oder eine Flüssigkeit wie beispielsweise Wasser oder vorzugsweise Öle bzw. für den Kristall inerte Flüssigkeiten und/oder ein Wärmestrahler oder Absorber. Wird das Element mittels eines Fluids temperiert, dann ist es bevorzugt, nur solche Stellen für die Kühlung anzuströmen, die optisch nicht benötigt bzw. durchstrahlt werden.

In einer weiteren bevorzugten Ausführungsform wird der Strahl bzw. das Bündel linear-polarisierter Transversalwellen mittig, d. h. möglichst mittig durch das optische Element geleitet.

Mit der erfindungsgemäßen Anordnung bzw. Verfahren ist es auch möglich, die an insbesondere beschichteten und polierten Laserfenstern verstärkt auftretende Depolarisation zu vermeiden bzw. stark zu verringern.

In einer weiteren erfindungsgemäßen Ausführungsform wird linear-polarisiertes Licht durch ein optisches kristallines Element geleitet. Derartige optische kristalline Elemente sind insbesondere kubische Kristallsysteme wie kubische Granate, kubische Spinelle, kubische Perovskite und kubische M(II)- sowie M(IV)-Oxide. Zweckmäßige Kristalle sind Y₃Al₅O₁₂, Lu₃Al₅O₁₂, Ca₃Al₂Si₃O₁₂, K₂NaAlF₆, K₂NaScF₆, K₂LiAlF₆ und/oder Na₃Al₂Li₃F₁₂, (Mg, Zn)Al₂O₄, CaAl₂O₄, CaB₂O₄, ZrO₂:Y₂O₃ (Y-stabilisiertes ZrO₂), Y₂O₃ und/oder LiAl₅O₈ sowie BaZrO₃ und/oder CaCeO₃. Weitere besonders geeignete kubische Kristalle sind Erdalkali- und Alkalihalogenide, insbesondere Chloride oder Fluoride wie CaF₂, BaF₂, SrF₂, NaF, KF, CsF sowie Mischkristalle davon.

Die Erfindung soll anhand der folgenden Figuren und Beispiele näher erläutert werden.

Es zeigen:
Fig. 1 die Anordnung einer kristallinen Probe im Strahlengang;
Fig. 2 die Depolarisation in Abhängigkeit des Drehwinkel β₀ für verschiedene Proben;
Fig. 3 eine Versuchsanordnung zur Erzeugung eines Temperaturgradienten;
Fig. 4 den Temperaturverlauf an geheizter und gegenüberliegender Fläche beim Ein- und Ausschalten eines Heizelementes;
Fig. 5 die Depolarisation eines Laserstrahls gemessen an einer Anordnung gemäß Fig. 3;
Fig. 6 eine Versuchsanordnung zur Einstellung eines Temperaturgradienten senkrecht und parallel zur Strahlrichtung;
Fig. 7 die Depolarisation bei Anlegen eines Temperaturgradienten senkrecht und parallel zur Strahlrichtung gemessen mit der Anordnung gemäß Fig. 6;
Fig. 8 eine Versuchsanordnung zur Bestimmung des Einflusses eines Temperaturgradienten auf die Depolarisation an einem Laserfenster; und
Fig. 9 die Depolarisation gemessen mit einer Anordnung nach Fig. 8.
Die Fig. 10 und 11 zeigen die Depolarisation durch ein Fenster in Abhängigkeit des Winkels β₁.

Es wurden 5 Kristallproben aus CaF₂ mit einer Länge von 100 mm hergestellt sowie ein kommerziell erhältliches CaF₂-Laserfenster mit der Oberflächenorientierung [111] und einer Dicke von 7 mm. Die einzelnen Proben sind der folgenden Tabelle I zu entnehmen.

**TABELLE I**

| **Probe** | **d (in mm)** | **Orientierung der Stirnflächen** | **Orientierung der Seitenflächen** |
|---|---|---|---|
| 1 | 100 | {110} | {001} und {1-10} |
| 2 | 100 | {100} | {011} und {0-11} |
| 3 | 100 | {111} | {11-2} und {1-10} |
| 4 | 100 | random | |
| 5 | 100 | random | allseitig poliert |
| 6 Laserfenster | 7 | {111} | |

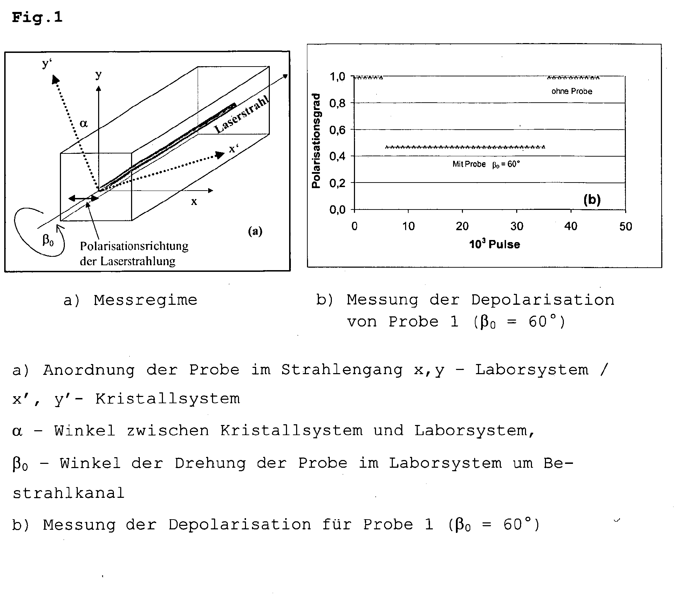

Fig. 1 zeigt eine Versuchsanordnung zur Bestimmung des Polarisationsgrades der Strahlung. Dabei wurde zuerst die Depolarisation des Laserstrahls ohne Probe bestimmt und anschließend die jeweils zu untersuchende Probe in den Strahlengang eingebracht und, der Kristall bezogen auf die Strahlrichtung als Drehachse, um einen Winkel βo gedreht. Der angezeigte Winkel α gibt den Winkel zwischen dem Kristallsystem (Kristallachsen x',y' und den Laborachsen (x,y, Strahlengang).

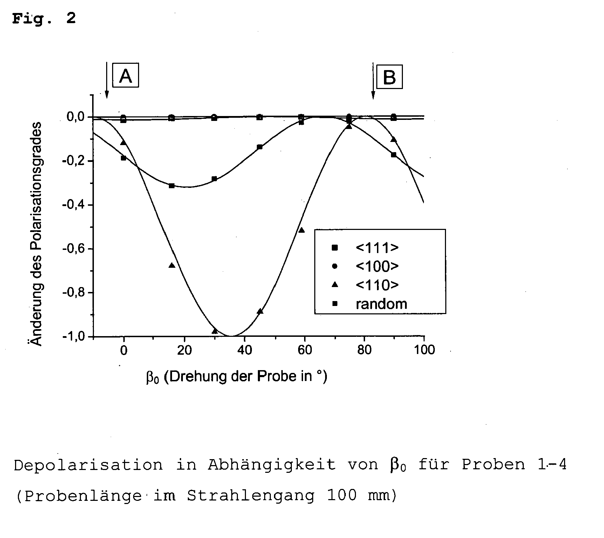

Entsprechend der in Fig. 1 gezeigten Versuchsanordnung wurden nun die Depolarisation bezogen auf den Winkel β₀ für verschiedene Kristallorientierungen gemessen. Die Ergebnisse sind in Fig. 2 dargestellt. Wie sich daraus entnehmen lässt, ist die Depolarisation für die Proben 2 und 3, d. h. Stirnoberfläche {111} bzw. {100} am geringsten, dagegen zeigt die Stirnoberfläche {110} (Probe 1) die stärkste Depolarisation und die random orientierte Probe 4 eine Depolarisierung, die im Bereich zwischen den Proben 2/3 und 1 liegt, wenn die Laserstrahlung senkrecht zur Stirnfläche einfällt. Des weiteren ist ersichtlich, dass die Depolarisation für sämtliche Proben dann am geringsten ist, wenn der Strahl im Kristall entlang der 〈100〉- oder der 〈111〉-Kristallachse verläuft und dass es für Einstrahlung entlang der 〈110〉-Kristallachse und auch random einen Winkel β₀ gibt, für den die Depolarisation minimal ist.

Es wurde auch gefunden, dass die Depolarisation von der Repetitionsrate R und der Energiedichte H unabhängig ist. Die Bestrahlungen wurden mit R = 100 Hz und H = 7 mJ/cm² durchgeführt. Dabei entsprach die totale Depolarisation der Phasenverschiebung Pi/2, was bei der Wellenlänge der Strahlung von 193 nm einer Verzögerung von 48 nm bzw. 4,8 nm/cm entspricht. Die minimale Depolarisation für die 〈110〉 orientierte Probe wurde dann erreicht, wenn die Probe so im Strahlengang angeordnet wurde, dass die Polarisationsrichtung des Laserstrahls in der Kristallebene {001} (Fig. 2a) bzw. {1-10} (Fig. 2b) liegt.

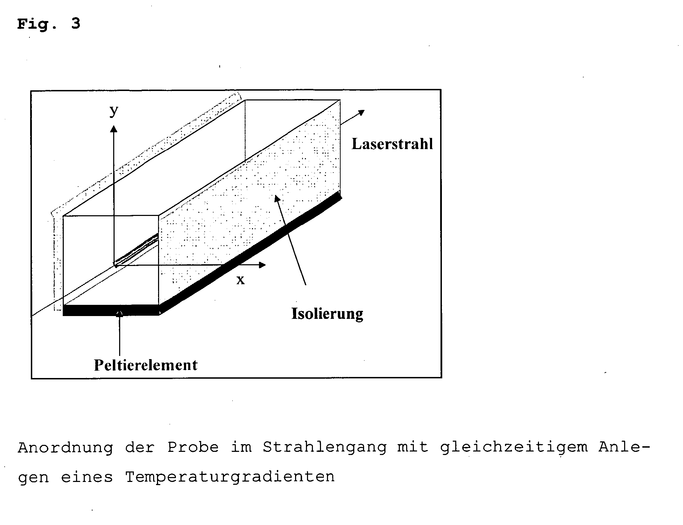

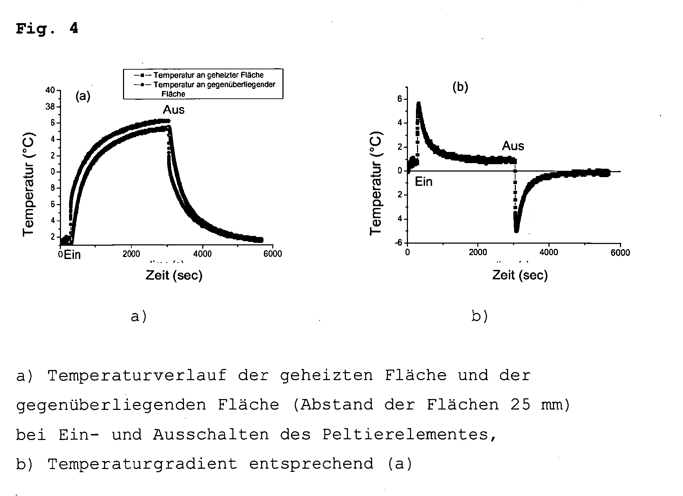

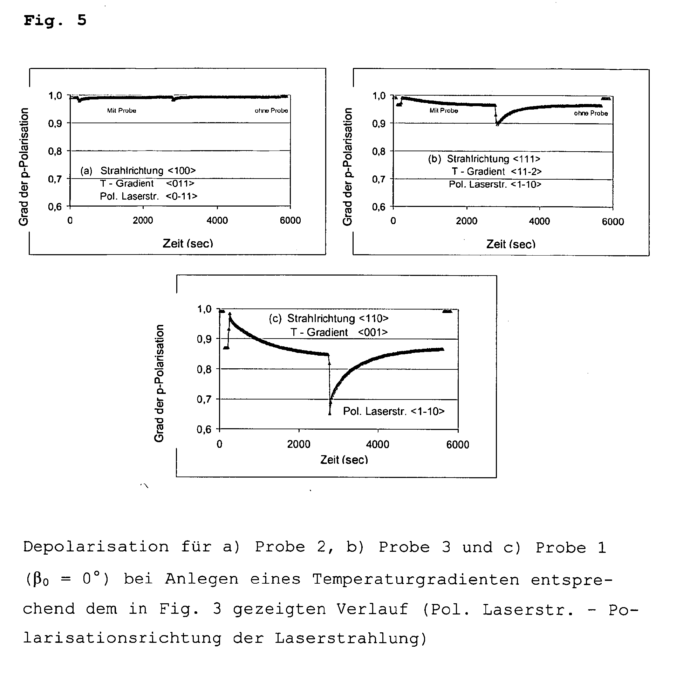

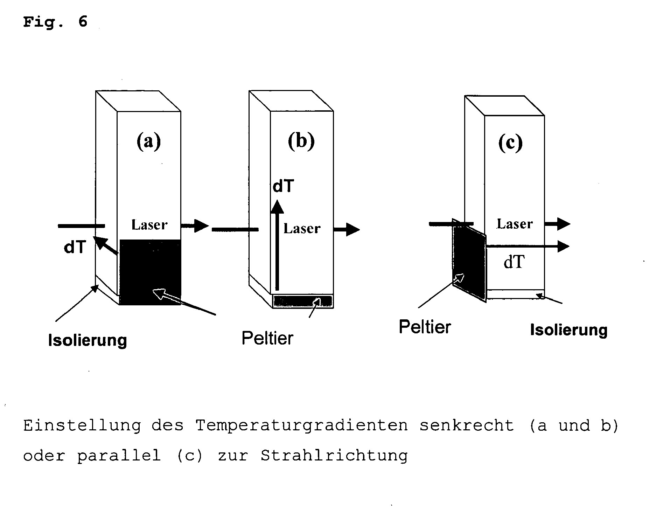

Fig. 3 zeigt eine Anordnung zur Bestimmung des Temperaturgradienten senkrecht zur Strahlrichtung auf die Depolarisation. Dabei wird ein Laserstrahl durch die Kristallprobe senkrecht zu dem durch ein Peltierelement erzeugten Temperaturgradienten geleitet. Die Ergebnisse sind in Fig. 4 a) und b) dargestellt. Dabei zeigt Fig. 4a den Temperaturverlauf an geheizter und an gegenüberliegender Fläche nach Ein- bzw. Ausschalten des Peltierelementes (Abstand der beiden Flächen 25 mm). Die absolute Temperaturerhöhung betrug ca. 14°C und der Temperaturgradient (Fig. 4b) erreichte einen maximalen Wert kurz nach dem Ein- bzw. Ausschalten von 5 - 6°C/25 mm.

Dieser maximale Wert klingt nach einiger Zeit ab, wodurch der Gradient geringer wird und schließlich einen annähernd konstanten Wert annimmt.

Mit der in Fig. 4 dargestellten Anordnung wurde die Depolarisation in Abhängigkeit der Kristallorientierung zu Strahlrichtung und zur Richtung des Temperaturgradienten untersucht. Die Ergebnisse sind in Fig. 5 dargestellt. Dabei zeigen Fig. 5 a-c jeweils die Proben 2, 3, und 1 für den Winkel β₀ = 0 beim Anlegen eines Temperaturgradienten. Der Temperaturgradient entsprach dem in Fig. 4 gezeigten Verlauf.

Wie aus den Figuren zu entnehmen ist, folgt die Depolarisation dem Verlauf des Temperaturgradienten. Kurz nach Ein- bzw. Ausschalten des Peltierelements nimmt die Depolarisation einen Extremwert an. Mit Abnahme des angelegten Temperaturgradienten nimmt auch die Depolarisation wieder ab. Erfindungsgemäß wurde gefunden, dass dieser Verlauf unabhängig von der Orientierung des Kristalls zur Laserrichtung ist. Der Effekt ist jedoch am stärksten bei der Kristallorientierung 〈110〉 in Strahlrichtung und am geringsten für die Kristallorientierung 〈100〉 in Strahlrichtung ausgeprägt. Die Kristallachsen sind hier im kubischen Kristall identisch mit den Oberflächennormalen auf den Kristallebenen im Koordinatensystem des reziproken Gitters.

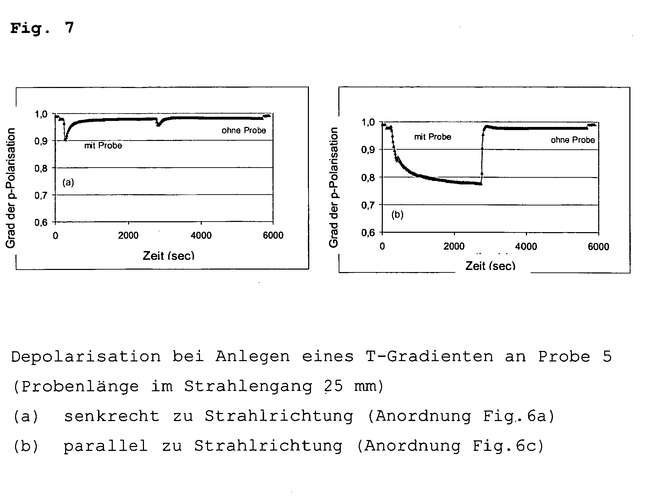

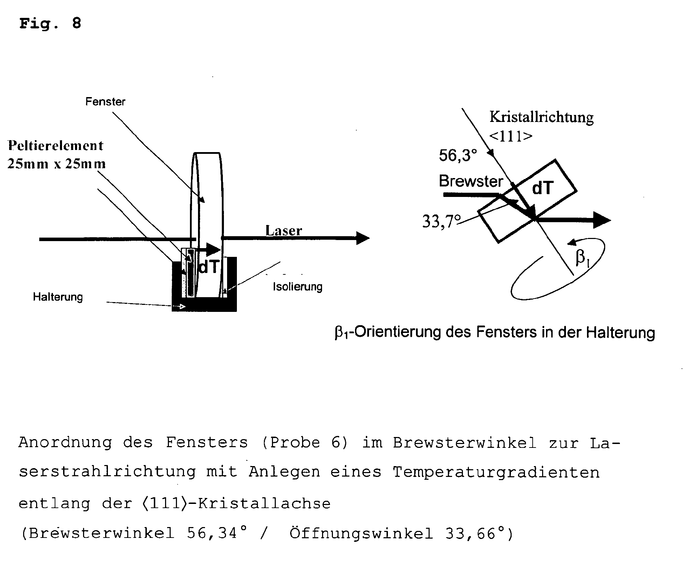

Mit der Erfindung wurde auch der Einfluss der Richtung des Temperaturgradienten zur Strahlrichtung auf die Depolarisation untersucht. Die Versuchsanordnung ist in Fig. 6 a-c dargestellt, wobei die Fig. 6 a und b die Einstellung eines Temperaturgradienten senkrecht und Fig. 6c parallel zur Strahlrichtung zeigen. Liegen Temperaturgradient und Strahlrichtung am Beispiel der Probe 5 senkrecht zueinander, so entstehen Spannungen in Strahlrichtung. Dies ist in den Figuren 3 sowie 6 a und b dargestellt. Ein derartiger Temperaturgradient bewirkt eine starke kurzzeitige Änderung des Polarisationsgrades, wie dies den Figuren 5 a-c sowie 7a zu entnehmen ist. Ein Temperaturgradient, der parallel zur Strahlrichtung verläuft (Fig. 6c) zeigt die in Fig. 7b angegebene Wirkung. Die in den jeweiligen Anordnungen Fig. 6 a-c angelegten Temperaturgradienten betrugen jeweils 10°C/25 mm. Wie sich den Fig. 7 entnehmen lässt, zeigt die Richtung des Temperaturgradienten einen starken Einfluss auf die Depolarisation. Steht der Temperaturgradient senkrecht zur Strahlrichtung, so wird nur eine kurzzeitige Depolarisation erhalten (Fig. 7a). Verläuft jedoch der Gradient parallel zur Strahlrichtung, so ist eine starke Depolarisation zu sehen, insbesondere über den gesamten Zeitraum, über den die Temperaturerhöhung bzw. der Temperaturgradient angelegt wird.

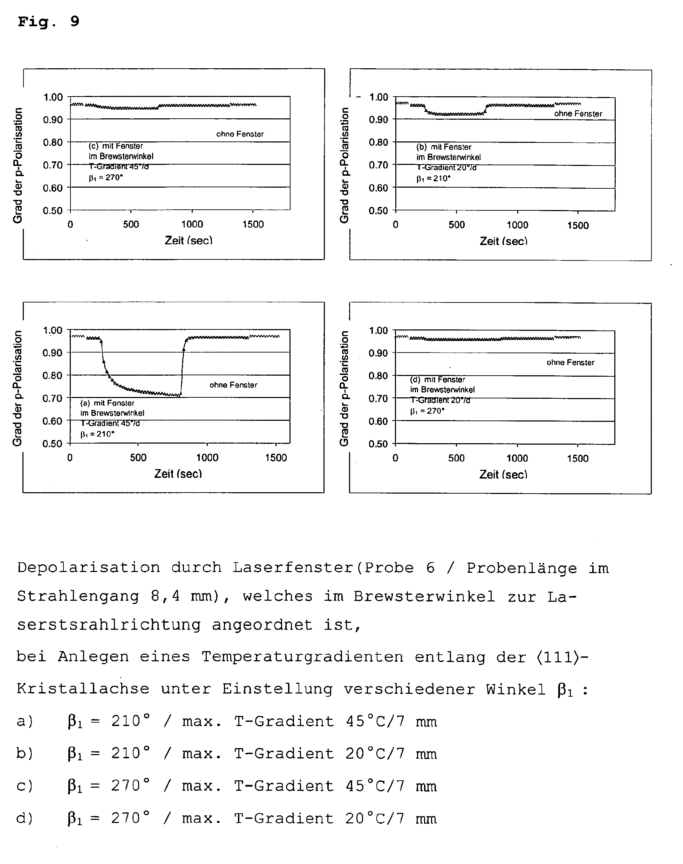

Darüber hinaus wurde auch noch der Einfluss der Orientierung des Temperaturgradienten zur Strahlrichtung auf die Depolarisation untersucht, und zwar für einen Einfallswinkel, bei dem sich der Temperaturgradient aus den Anteilen parallel und senkrecht zur Strahlrichtung zusammensetzt (z. B. 45-75°, insbesondere Brewsterwinkel). Dabei wurde die in Fig. 8 a und b gezeigte Anordnung gewählt. Wie in Fig. 8 gezeigt, wird ein Laserstrahl im Brewsterwinkel von 56,3°C auf die {111}-Stirnfläche gerichtet. Dabei gibt β₁ die Orientierung des Fensters bzw. des Kristalls in der Halterung an. Entlang der Durchstrahlrichtung des Kristalls wurden nun verschiedene Temperaturgradienten bei verschiedenen Winkeln β₁ angelegt. Die Ergebnisse sind in den Fig. 9 a-d dargelegt.

Bei dieser Anordnung wurden mittels eines Peltierelements zwei verschiedene Temperaturgradienten über die Kristalldicke (d = 7 mm) eingestellt, und zwar 20°C bzw. 45°C/7 mm. Wie sich der Fig. 9 entnehmen lässt, zeigt die Depolarisation bei Änderung des Winkels β₁ einen deutlichen Unterschied. Dabei zeigte sich, dass die Anlegung eines Temperaturgradienten bei einem β₁-Winkel von 270°C (was annähernd der Einstrahlung entlang der 〈100〉-Achse im Kristall entspricht) die Depolarisation vernachlässigbar klein ist bzw. innerhalb des Messfehlerbereichs liegt.

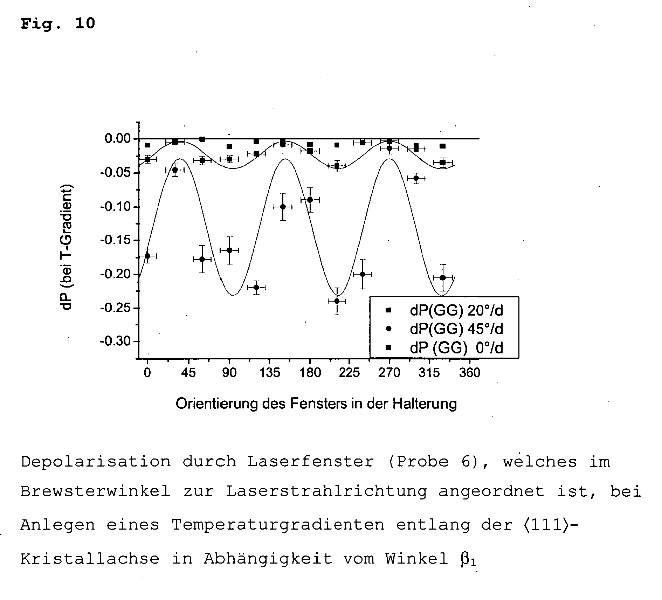

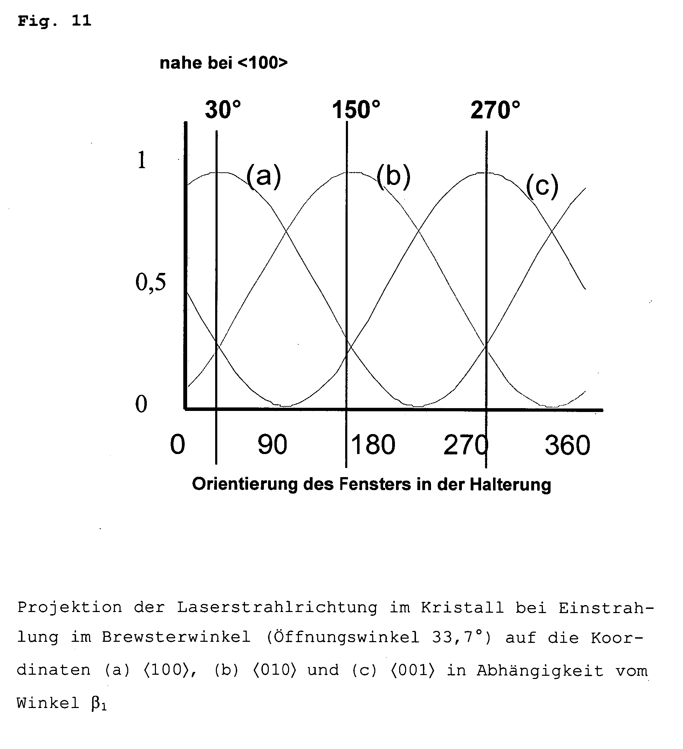

Durch Drehen des Fensters in der Halterung von Fig. 8 um β₁ wurde die Kristallorientierung in Strahlrichtung verändert. Das Ergebnis ist in Fig. 10 dargestellt. Darin wird die Depolarisation der Laserstrahlung, die im Brewsterwinkel zur Oberflächennormale ein (111)- orientiertes Laserfenster durchstrahlt, bei Anliegen eines Temperaturgradienten senkrecht zu den Stirnflächen (entlang der 〈111〉-Kristallachse) in Abhängigkeit des Winkels β₁ angegeben. Fig. 11 zeigt die berechnete Projektion der Laserstrahlrichtung im Laserfenster bei Einstrahlung im Brewsterwinkel und Änderung des Winkels β₁. Bei 30°, 150° und 270° wird annähernd entlang der Kristallachse (100) eingestrahlt. Dies entspricht den Minima der Depolarisation in Fig. 10.

Das erfindungsgemäße Verfahren sowie die dazugehörige Anordnung ist besonders für TFT-Bildschirme sowie für optische Komponenten in der DUV-Lithographie, sowie zur Herstellung von elektronischen Geräten geeignet. Die Erfindung betrifft daher auch Linsen, Prismen, Lichtleitstäbe, optische Fenster sowie optische Geräte für die DUV-Lithographie, insbesondere auch Stepper und Excimer-Laser und ihre Verwendung zur Herstellung von integrierten Schaltungen, Computerchips sowie elektronischen Geräten wie Computern sowie anderen Geräten, welche chipartige integrierte Schaltungen enthalten.

## Patentansprüche

1. Vorrichtung zur Herstellung und Vermeidung bzw. Verringerung der Depolarisation von linear polarisiertem Licht beim Durchstrahlen von Kristallen, die eine {111}- bzw. {100}-Kristallebene und eine 〈100〉- bzw. 〈111〉-Kristallachse aufweisen, **dadurch gekennzeichnet, dass** die Oberfläche der Kristalle von der {111}- oder {100}-Ebene gebildet werden, auf die das linear-polarisierte Licht in einem Winkel von 45-75° auftrifft und der Kristall derart angeordnet ist, dass das Licht nach seinem Eintritt im Kristall sich so parallel wie möglich entlang der 〈100〉- bzw. 〈111〉-Kristallachse ausbreitet und/oder dass die Anordnung zur Verhinderung eines Temperaturgradienten im Kristall eine Temperiereinheit umfasst.

2. Vorrichtung nach Anspruch 1, **dadurch gekennzeichnet, dass** das Licht im Brewsterwinkel auftrifft.

3. Vorrichtung nach Anspruch 1 zur Herstellung von linear polarisiertem Licht, umfassend eine Einheit zur Erzeugung von kohärentem verstärktem Licht mittels stimulierter Emission, die einen optischen, ein laseraktives Medium enthaltenden Resonatorraum mit mindestens einem Austrittsfenster zum Auskoppeln von Laserlicht und eine Energiepumpe zur Erzeugung von Laserübergängen im aktiven Medium umfasst sowie gegebenenfalls weitere von Laserlicht durchstrahlte optische Elemente, **dadurch gekennzeichnet,**
**dass** das Austrittsfenster des Resonators und/oder die weiteren vom Laserlicht durchstrahlten Elemente aus einem kristallinen Material bestehen, das derart angeordnet ist, dass die {111}- oder {100}-Ebene die Oberfläche bildet, auf die das Laserlicht auftrifft und
**dass** das Laserlicht sich innerhalb des Kristalls so parallel wie möglich zur 〈100〉- bzw. 〈111〉-Kristallachse ausbreitet.

4. Vorrichtung nach Anspruch 1 bis 3, **dadurch gekennzeichnet, dass** sie ein Festkörperlaser oder Gaslaser ist.

5. Vorrichtung nach einem der vorhergehenden Ansprüche zur Herstellung von linear polarisiertem Licht, umfassend eine Einheit zur Erzeugung von kohärentem verstärkten Licht mittels stimulierter Emission mit einem optischen, ein laseraktives Medium enthaltenden Resonatorraum mit mindestens einem Austrittsfenster zum Auskoppeln von Laserlicht und einer Energiepumpe zur Erzeugung von Laserübergängen im aktiven Medium sowie gegebenenfalls weiteren von Laserlicht durchstrahlten optischen Elementen, **dadurch gekennzeichnet, dass** sie eine Temperiereinheit für das Austrittsfenster und/oder die vom Laserlicht durchstrahlten optischen Elemente umfasst, welche im Austrittsfenster und/oder den vom Laserlicht durchstrahlten optischen Elementen die Ausbildung von Temperaturgradienten in Strahlrichtung verhindert.

6. Vorrichtung nach einem der vorhergehenden Ansprüche, **dadurch gekennzeichnet, dass** die Temperiereinheit die Ausbildung eines Temperaturgradienten in sämtliche Raumrichtungen verhindert.

7. Vorrichtung nach einem der vorhergehenden Ansprüche, **dadurch gekennzeichnet, dass** die Temperiereinheit eine Wärme- und/oder Kühlvorrichtung umfasst.

8. Vorrichtung nach einem der vorhergehenden Ansprüche, **dadurch gekennzeichnet, dass** die Temperiereinheit ein Peltierelement und/oder einen temperierbaren Gasstrom und/oder Wärmestrahler umfasst.

9. Vorrichtung nach einem der vorhergehenden Ansprüche, **dadurch gekennzeichnet, dass** die Temperiereinheit mindestens die Temperatur der heißesten Stelle im durchstrahlten Material erzeugt.

10. Vorrichtung nach einem der vorhergehenden Ansprüche, **dadurch gekennzeichnet, dass** das Austrittsfenster und/oder die weiteren durchstrahlten optischen Elemente derart angeordnet sind, dass sie vom Laserstrahl so mittig wie möglich durchdrungen werden.

11. Vorrichtung nach einem der vorhergehenden Ansprüche, **dadurch gekennzeichnet, dass** das Austrittsfenster und/oder die weiteren durchstrahlten optischen Elemente aus einem kubisch kristallinen Material oder Glas besteht.

12. Vorrichtung nach einem der vorhergehenden Ansprüche, **dadurch gekennzeichnet, dass** das kristalline Material CaF₂, SrF₂, BaF₂, Y₂O₃, Y₃Al₅O₁₂ (YAG), Lu₃Al₅O₁₂ (LuAG), MgAl₂O₄ (Spinell) und/oder ZrO₂:Y₂O₃ (Y-in der kubischen Phase stabilisiertes ZrO₂), NaCl ist.

13. Verfahren zur Vermeidung und/oder Minimierung der Depolarisation von linear polarisiertem Licht beim Durchstrahlen von Kristallen, die eine {111}- bzw. {100}-Ebene und eine 〈100〉- bzw. 〈111〉-Kristallachse aufweisen, **dadurch gekennzeichnet, dass** als Kristalloberfläche, auf welche das polarisierte Licht trifft, die {111}- bzw. {100}-Ebene verwendet und der Kristall derart angeordnet wird, dass das linear-polarisierte Licht auf die {111}- bzw. {100}-Oberflächenebene in einem Winkel von 45-75° auftrifft und dass das Licht sich im Kristall so parallel wie möglich entlang der 〈100〉- oder der 〈111〉-Kristallachse ausbreitet und/oder mittels einer Temperiereinheit einen Temperaturgradienten im Kristall verhindert.

14. Verfahren nach Anspruch 13, **dadurch gekennzeichnet, dass** das Licht im Brewsterwinkel auf die {111}- bzw. {100}-Oberfläche auftrifft.

15. Verwendung der Vorrichtung nach einem der Ansprüche 1 bis 11 und/oder des Verfahrens nach Anspruch 13 bis 14 in der DUV-Lithographie, insbesondere in Steppern und Excimer-Lasern sowie zur Herstellung von integrierten Schaltungen, Computerchips sowie elektronischer Geräte wie Computern sowie anderer Geräte, welche chipartige integrierte Schaltungen enthalten, sowie von Flachbildschirmen.
